# DEMANDE DE BREVET EUROPEEN

(11) **EP 1 528 118 A2**
(43) Date de publication de la demande: **04.05.2005**
(21) Numéro de dépôt: 04292489.4
(22) Date de dépôt: 20.10.2004
(51) Int. Cl.: C23C 14/00, C23C 28/00, C23C 16/00, F01D 5/00

(54) **Pièce de turbine à gaz muni d'un revêtement de protection et procédé de sa réalisation**

(30) Priorité: 28.10.2003 FR 0312619
(71) Demandeur: Sneca Moteurs, 75015 Paris (FR)
(72) Inventeur: Saint Ramond, Bertrand, 77300 Fontainebleau (FR); Silva, Manuel, 14000 Caen (FR); Nicholls, John, Milton Keynes - Bucks MK17 ORH (GB); Carlin, Maxime, Flitwick, MK45 1LD Bedfordshire (GB)
(74) Mandataire: Joly, Jean-Jacques

(57) **Abrégé**

Une pièce de turbine à gaz comprend un substrat métallique en superalliage, une sous-couche de liaison formée sur le substrat et comportant un composé intermétallique comprenant de l'aluminium, du nickel et du platine, et un revêtement externe en céramique ancré sur un film d'alumine formé sur la sous-couche de liaison. La sous-couche de liaison comprend essentiellement un système ternaire Ni-Pt-Al constitué d'une structure de type α-NiPt additionnée d'aluminium, notamment un système ternaire Ni-Pt-Al ayant une composition Ni_{z}Pt_{y}Alₓ dans laquelle z, y, x sont tels que 0,150,05 ≤ z ≤ 0,550,40, 0,15 0,30 ≤ y ≤ 0,550,60 et 0,200,15 ≤ x ≤ 0,40.

## Description

### Arrière-plan de l'invention

L'invention concerne la réalisation de revêtement de protection sur un substrat métallique en superalliage.

Le domaine d'application de l'invention est la réalisation de pièces capables de conserver leur tenue mécanique à des températures élevées, en particulier des pièces de turbines à gaz, telles que des aubes de turbine, notamment pour des turboréacteurs.

Pour améliorer les performances, en particulier le rendement, il est souhaitable de faire fonctionner des turbines à gaz aux températures les plus élevées possibles. Pour la réalisation de pièces des parties chaudes, il est couramment fait appel à des superalliages. Habituellement ceux-ci comprennent du nickel, comme constituant principal, et des éléments additionnels généralement choisis parmi le chrome, le cobalt, l'aluminium, le molybdène, le titane, le tantale, et bien d'autres.

Un accroissement de la température de fonctionnement est rendu possible en munissant le substrat métallique des pièces d'un revêtement de protection formant une barrière thermique.

Il est connu à cet effet de réaliser un revêtement de protection comprenant une couche externe en céramique et une sous-couche de liaison métallique, en particulier une sous-couche de liaison contenant de l'aluminium et au moins un autre métal, tel que du platine.

La sous-couche de liaison interposée entre le substrat métallique en superalliage et la couche externe céramique a pour fonctions :
- de permettre la formation et la persistance à sa surface d'un film d'alumine favorisant l'accrochage de la couche externe céramique,
- de protéger le substrat de la corrosion par oxydation par de l'oxygène du milieu ambiant ayant pu traverser la couche céramique externe, et
- de constituer une barrière de diffusion vis-à-vis de certains éléments du substrat métallique qui seraient susceptibles de contaminer le film d'alumine et, par voie de conséquence, d'affecter l'interface entre la sous-couche de liaison et la couche céramique externe, donc d'affecter l'adhérence de cette dernière.

L'introduction au sein de la sous-couche de liaison, d'éléments réactifs tels que l'yttrium, le cérium, l'hafnium ou les lanthanides, renforce la fonction de barrière de diffusion et favorise la persistance du film "adhésif" d'alumine.

Il est bien connu de former une sous-couche de liaison de type MCrAlY (M étant un métal tel que Fe, Ni, Co) par un procédé tel que projection plasma, sans induire de réaction avec le substrat, l'adhésion de la sous-couche de liaison sur le substrat étant de nature mécanique. On pourra se référer par exemple aux documents US 4 055 705 et US 5 824 423. Toutefois, afin d'obtenir une sous-couche stable thermiquement, il est nécessaire de lui conférer une épaisseur relativement importante, typiquement au moins 50 à 100 µm, ce qui est pénalisant en terme de masse.

D'autres procédés connus consistent à réaliser une sous-couche de liaison en un composé intermétallique qui, du fait de sa stabilité thermique, peut avoir une épaisseur plus faible. Un composé intermétallique comprenant de l'aluminium et du platine a démontré de bonnes propriétés.

Ainsi, les brevets US 5 716 720 et US 5 856 027 décrivent un procédé consistant à former une couche de platine par voie électrolytique sur un substrat en superalliage à base de nickel et à réaliser ensuite une aluminisation en phase vapeur à une température supérieure à 1 000°C. Du nickel provenant du substrat diffuse au sein de la sous-couche de liaison. Un film d'alumine est formé par traitement thermique à la surface de la sous-couche de liaison avant formation d'une couche externe céramique par exemple en zircone yttriée obtenue par dépôt physique en phase vapeur. Un élément réactif peut être introduit dans la sous-couche de liaison lors de l'étape d'aluminisation en phase vapeur. Dans sa partie externe surmontant une zone de diffusion au voisinage du substrat, la sous-couche de liaison présente une phase intermédiaire comprenant 18 % à 28 % en poids d'aluminium, 50 % à 60 % en poids de nickel et 8 % à 35 % en poids de platine correspondant à une phase de solution solide de type β du diagramme de phase binaire nickel-aluminium (β-NiAl).

Le brevet US 5 238 752 décrit un autre procédé consistant à former sur un substrat en superalliage une sous-couche de liaison en un composé intermétallique, notamment un composé d'aluminium et de platine. La sous-couche de liaison est réalisée par cémentation en pack à une température supérieure à 985°C et a une épaisseur supérieure à 25 µm. Un film d'alumine est formé par oxydation à la surface de la sous-couche de liaison avant la formation d'une couche externe céramique, par exemple en zircone yttriée par dépôt physique en phase vapeur.

La demande de brevet EP 0 985 744 décrit encore un autre procédé comprenant la formation d'une couche de platine sur un substrat en superalliage à base nickel par électrodéposition ou par dépôt chimique en phase vapeur et le dépôt d'une couche d'aluminium qui est formée à partir d'un halogénure gazeux et qui diffuse dans la couche de platine. Une désulfurisation est effectuée après chaque dépôt par traitement thermique à une température supérieure à 1050°C et écroûtage superficiel, afin d'éliminer le soufre nuisible à l'adhérence du film d'alumine développé à la surface de la sous-couche de liaison obtenue.

On connaît encore de la demande de brevet US 2002 0037220 un procédé selon lequel la sous-couche de liaison est formée par dépôt physique en phase vapeur d'une pluralité de couches élémentaires alternativement en un métal du groupe du platine et en aluminium, et par réaction exothermique entre les métaux des couches formées. Du fait de l'utilisation d'un procédé de dépôt physique en phase vapeur, la température du substrat est relativement peu élevée, et reste à une valeur bien inférieure à celle à partir de laquelle des éléments du substrat sont susceptibles de diffuser dans le dépôt formé.

### Objet et résumé de l'invention

Un but de l'invention est de réaliser une pièce de turbine à gaz comprenant un substrat métallique en superalliage muni d'un revêtement de protection avec une sous-couche de liaison entre substrat et couche externe céramique qui soit stable et présente une résistance durable à l'écaillage de la couche céramique, tout en ayant une épaisseur faible, donc une masse peu élevée.

Ce but est atteint grâce à une pièce de turbine à gaz comprenant un substrat métallique en superalliage, une sous-couche de liaison formée sur le substrat et comportant un composé intermétallique comprenant de l'aluminium, du nickel et du platine, et un revêtement externe en céramique ancré sur un film d'alumine formé sur la sous-couche de liaison,
dans laquelle, conformément à l'invention, la sous-couche de liaison comprend essentiellement un système ternaire Ni-Pt-Al constitué d'une structure de type α-NiPt additionnée d'aluminium.

Une caractéristique de l'invention réside dans la présence au moins majoritaire dans la sous-couche de liaison d'une phase de solution solide de type α dans le diagramme de phase binaire nickel (Ni)-platine (Pt) incorporant en outre de l'aluminium (Al).

C'est en raison de la grande stabilité d'une telle phase qu'une sous-couche de liaison peut être réalisée, même en faible épaisseur, sans affecter les propriétés et notamment la robustesse de la protection thermique. Celle-ci présente une résistance accrue à l'écaillage, même après des cyclages thermiques répétés.

En outre, dans le cas d'un substrat en superalliage à base nickel, la diffusion dans le temps de nickel du substrat vers la couche de liaison peut modifier la composition de celle-ci mais non la structure et donc la stabilité du composé intermétallique α-NiPt, et ce d'autant que la teneur initiale en nickel est plus proche de la valeur minimale du domaine α-NiPt.

Une phase de solution solide NiPt de type α additionnée d'Al est connue en elle-même et peut être caractérisée par sa structure cristallographique telle que celle décrite notamment dans un article de Janice L. Kann et al intitulé "Phase Stability in (Ni, Pt)₃Al Alloys" et paru dans Scripta Metallurgica et Materiala, Vol. 31, N° 11, p. 1461-1464, 1994.

Une référence à une telle phase peut aussi être trouvée dans un article de B. Gleeson et al intitulé "Effects on Platinium on the Interdiffusion and Oxidation Behavior of Ni-Al-Based Alloys" et paru dans Proceedings of the 6th International Symposium on High Temperature Corrosion and Protection of Materials, Materials Science Forum, Vols 461-464, p. 213-222, 2004.

Avantageusement, le système ternaire Ni-Pt-Al de la sous-couche de liaison a une composition Ni_{z}Pt_{y}Alₓ dans laquelle z, y, x sont tels que 0,05 ≤ z ≤ 0,40, 0,30 ≤ y ≤ 0,60 et 0,15 ≤ x ≤ 0,40.

La sous-couche de liaison peut comprendre un ou plusieurs métaux supplémentaires autres que Al, Ni et Pt, notamment au moins un métal choisi parmi le chrome et le cobalt qui contribuent à la stabilité, et/ou au moins un métal précieux choisi parmi le palladium, le ruthénium et le rhénium.

La sous-couche de liaison peut encore comprendre au moins un élément réactif choisi dans le groupe constitué par l'yttrium, le zirconium, l'hafnium et les lanthanides.

Dans tous les cas la sous-couche de liaison reste majoritairement formée par le système ternaire Ni-Pt-Al, celui-ci représentant de préférence au moins 75 % (en pourcentage atomique) de la composition de la sous-couche.

L'épaisseur de la sous-couche de liaison est avantageusement comprise entre 2 microns et 120 microns, et de préférence inférieure à 40 microns. On pourra même choisir une épaisseur plus faible, inférieure à 20 microns en raison de la stabilité conférée par la présence de la phase α-NiPt, et donc limiter le coût de mise en oeuvre et la masse de la sous-couche de liaison.

Un autre but de l'invention est de fournir un procédé pour la réalisation d'un revêtement de protection formant barrière thermique sur un substrat métallique en superalliage avec une sous-couche de liaison stable et pouvant avoir une faible masse.

Ce but est atteint grâce à un procédé comprenant la formation, sur le substrat, d'une sous-couche de liaison comportant un composé intermétallique comprenant de l'aluminium, du nickel et du platine, et la formation d'une couche externe en céramique qui s'ancre sur un film d'alumine présent sur la sous-couche de liaison,
procédé dans lequel, conformément à l'invention, on forme une sous-couche de liaison comprenant essentiellement un système ternaire Ni-Pt-Al constitué d'une structure de type α-NiPt additionnée d'aluminium.

Selon un mode de mise en oeuvre du procédé, la sous-couche de liaison est réalisée par formation sur le substrat d'un revêtement de composition correspondant à la composition souhaitée de la sous-couche. On utilise alors un processus de formation de revêtement de type "overlay", c'est-à-dire ne faisant pas intervenir de façon substantielle ou notable la diffusion dans le revêtement d'éléments provenant du substrat.

Parmi les processus utilisables, on peut citer les dépôts physiques en phase vapeur, les dépôts par pulvérisation cathodique ou projection plasma, et les dépôts électrolytiques.

La sous-couche de liaison peut ainsi être formée par dépôt physique en phase vapeur d'au moins une pluralité de couches élémentaires respectivement en platine, nickel et aluminium, et par réaction entre les métaux des couches déposées.

On pourra aussi déposer au moins certaines couches comportant plusieurs composants de la sous-couche de liaison sous forme préalliée, par exemple déposer des couches préalliées telles que NiPt ou PtAl en alternant avec des couches Al ou Ni.

Il est encore envisageable de former la sous-couche de liaison par dépôt physique en phase vapeur à partir d'une source de composition correspondant à celle souhaitée pour la sous-couche de liaison, par exemple par projection plasma avec un mélange de poudres préalliées.

Selon un autre mode de mise en oeuvre de l'invention, la sous-couche de liaison est formée sur un substrat en superalliage à base nickel, par dépôt physique en phase vapeur d'au moins une pluralité de couches élémentaires alternativement en platine et en aluminium, par réaction exothermique entre les métaux des couches déposées à température modérée, c'est-à-dire inférieure à 900°C, typiquement de l'ordre de 700°C, et par traitement thermique afin de provoquer la diffusion dans la sous-couche de liaison de nickel venant du substrat. Le traitement thermique peut être réalisé séparément de la formation de la couche externe céramique ou résulter de la formation de la couche externe céramique lorsque celle-ci est réalisée à une température relativement élevée. Il a été observé par la déposante qu'un traitement thermique à une température au moins égale à 900°C suffit pour faire diffuser du nickel du substrat, dans toute la sous-couche de liaison, lorsque celle-ci a une épaisseur relativement faible, par exemple inférieure ou égale à 10microns, une température plus élevée pouvant être nécessaire lorsque l'épaisseur est plus grande. Il a été aussi observé que cette diffusion se traduit par la formation d'une phase stable de type α-Ni Pt.

### Brève description des dessins

L'invention sera mieux comprise à la lecture de la description faite ci-après, à titre indicatif mais non limitatif.

Il sera fait référence aux dessins annexés sur lesquels :
- la figure 1 est une vue très schématique en coupe d'un substrat métallique en superalliage muni d'un revêtement de protection ;
- la figure 2 illustre schématiquement une maille cristallographique caractéristique d'une phase de solution solide α-NiPt additionnée d'aluminium ;
- la figure 3 montre un mode de mise en oeuvre d'un procédé selon l'invention ;
- les figures 4 à 6 montrent des exemples de mise en oeuvre d'une première étape du procédé de la figure 3 ;
- la figure 7 montre un autre mode de mise en oeuvre d'un procédé selon l'invention ;
- la figure 8 est une photographie prise au microscope électronique à balayage montrant une coupe transversale de revêtement de protection réalisé conformément à un mode de mise en oeuvre de l'invention sur un substrat métallique en superalliage ;
- la figure 9 illustre des résultats d'essais effectués sur des pièces munies de revêtements conformément à l'invention et selon l'art antérieur ; et
- les figures 10 et 11 sont des photographies prises au microscope électronique à balayage montrant une coupe transversale de revêtement de protection réalisé selon un autre mode de mise en oeuvre de l'invention, avant et après traitement thermique.

### Description détaillée de modes de réalisation

Dans la description qui suit, on envisage la réalisation d'un revêtement de protection sur une pièce métallique en superalliage, typiquement une pièce de turbine à gaz telle qu'une aube de turbine de turboréacteur.

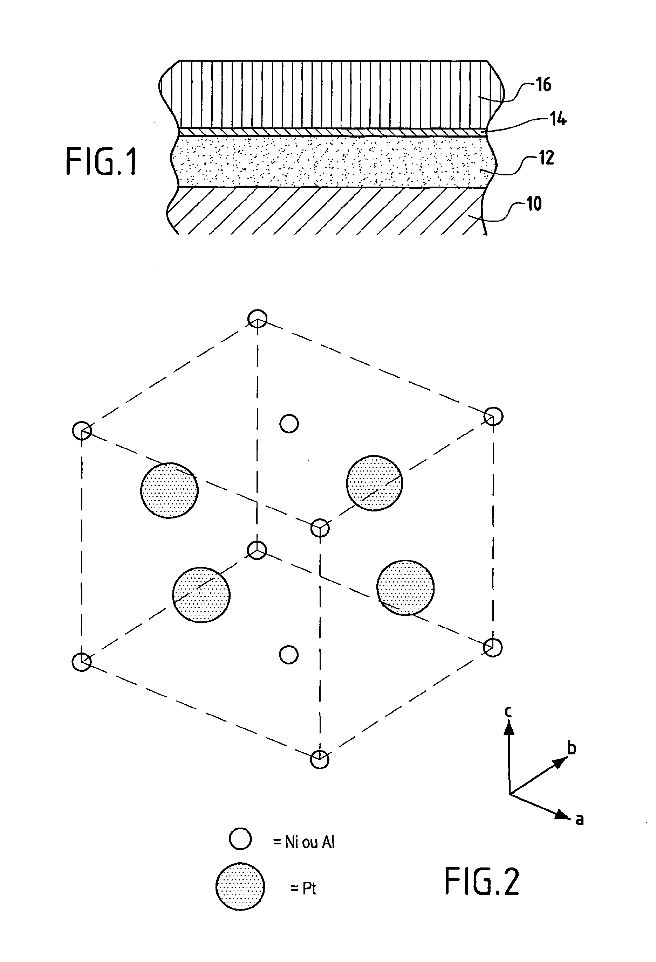

Le revêtement de protection est du type illustré très schématiquement par la figure 1. Sur un substrat métallique 10 en superalliage est formé un revêtement comprenant une sous-couche de liaison 12 en un composé intermétallique formé principalement d'aluminium, de nickel et de platine, et une couche externe céramique 16 ancrée sur un film d'alumine 14 développé à la surface de la sous-couche de liaison.

Conformément à l'invention, le composé intermétallique formant la sous-couche de liaison comprend, majoritairement, un système ternaire Ni-Pt-Al constitué d'une phase de type α-NiPt additionnée d'Al. Une telle phase peut être définie par sa structure cristallographique telle que montrée par la figure 2. Cette structure est un système quadratique à faces centrées de type L1ₒ. Les atomes Ni et Al sont disposés aux sommets et aux centres des faces (001) tandis que les atomes de Pt sont situés au centre des faces (100) et (010). Au niveau de la maille cristallographique, les dimensions a, b, c (figure 2) sont telles que 0,37 nm ≤ a = b ≤ 0,40 nm et 0,35 nm ≤ c ≤ 0,36 nm. On choisit de préférence un système ternaire Ni_{z}Pt_{y}Alₓ dans lequel z, y et x sont tels que 0,05 ≤ z ≤ 0,40, 0,30 ≤ y ≤ 0,60 et 0,15 ≤ x ≤ 0,40.

Le domaine contenant la phase α-NiPt est totalement séparé du domaine contenant la phase β-NiAl, comme confirmé par l'article précité de B. Gleeson et al.

Des éléments autres que Ni, Al, Pt peuvent être ajoutés à la composition de la sous-couche de liaison, notamment des éléments réactifs choisis parmi l'yttrium, le zirconium, l'hafnium et les lanthanides qui renforcent la fonction de barrière de diffusion vis-à-vis de certains éléments du substrat susceptibles d'être préjudiciables à la tenue du revêtement protecteur, et qui favorisent la persistance du film d'alumine 14. D'autres métaux peuvent aussi être ajoutés qui ont un effet bénéfique, par exemple du palladium, du ruthénium ou du rhénium ou encore du cobalt et/ou du chrome qui améliorent la stabilité thermique du revêtement.

Le film d'alumine 14 est produit par oxydation de l'aluminium de la barrière de diffusion. Il assure une fonction de protection vis-à-vis de la corrosion par oxydation. Il assure aussi, par son caractère "adhésif", l'accrochage du revêtement externe en céramique 16.

Le revêtement externe en céramique 16 assure essentiellement une fonction d'isolant thermique. Il est en oxyde réfractaire, tel que zircone, oxyde d'yttrium ou zircone yttriée. Il peut être formé par dépôt physique en phase vapeur, par exemple par évaporation par faisceau électronique ou par évaporation assistée par plasma, comme cela est bien connu en soi.

La composition (en pourcentages atomiques) de la sous-couche de liaison peut être la suivante :
entre 75 % et 100 % du système ternaire Ni-Pt-Al défini ci-avant,
entre 0 % à 10 % de cobalt et/ou chrome
entre 0 % et 5 % d'élément(s) réactif(s) choisis parmi Y, Zr, Hf et les lanthanides, et
entre 0 % et 10 % de métal précieux choisi parmi Pd, Ru et Rh.

L'épaisseur de la sous-couche de liaison est de préférence comprise entre 2 microns et 120 microns. En raison de la grande stabilité thermique conférée par la phase α-NiPt, cette épaisseur pourra être avantageusement inférieure à 40 microns, voire même à 20 microns.

### Premier mode de réalisation

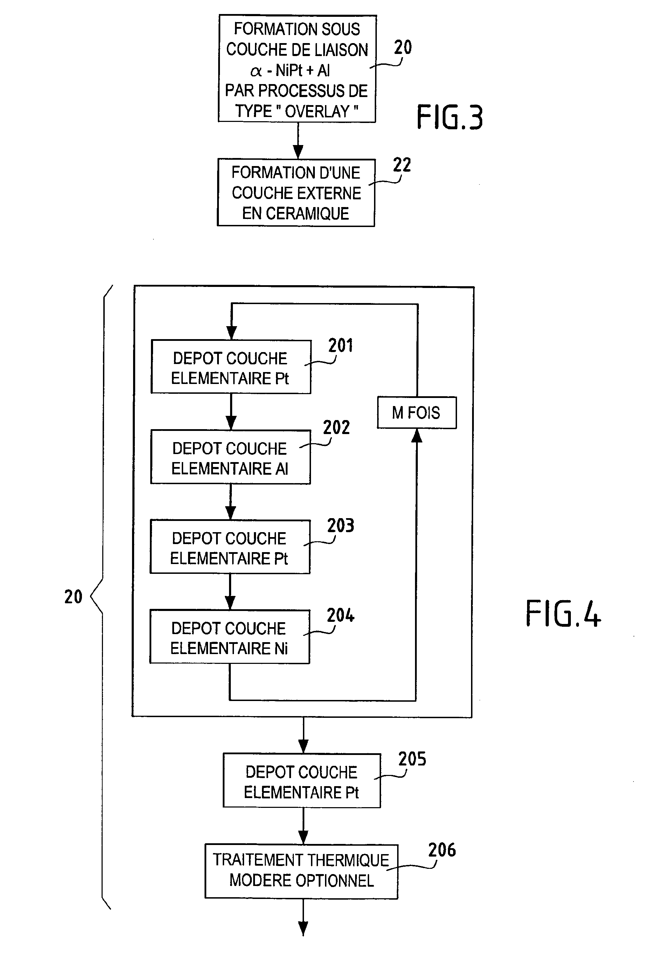

Selon un premier mode de réalisation (figure 3), la sous-couche de liaison est formée en réalisant un revêtement ayant la composition désirée de la sous-couche de liaison, sans provoquer de diffusion substantielle ou notable d'éléments provenant du substrat, c'est-à-dire en mettant en oeuvre un processus de type "overlay" (étape 20).

Ensuite (étape 22), une couche externe est formée sur la sous-couche de liaison avec croissance du film d'alumine développé à la surface de cette dernière. On pourra utiliser à cet effet un procédé de dépôt physique en phase vapeur sous faisceau d'électrons (EB-PVD). Les substrats métalliques munis de la sous-couche de liaison sont placés dans une enceinte au-dessus d'une source de céramique, par exemple une cible de zircone yttriée (stabilisée par de l'oxyde d'yttrium Y₂O₃). Le dépôt est réalisé sous atmosphère réduite formée d'un mélange d'argon et d'oxygène par excitation d'un canon à électrons en regard de la source de céramique. Il s'agit d'un procédé bien connu en soi.

L'étape 20 peut être réalisée de plusieurs façons, en mettant en oeuvre notamment un processus de dépôt physique en phase vapeur (PVD) tel que pulvérisation cathodique, dépôt PVD sous faisceau d'électrons (EB-PVD) ou évaporation sous arc avec ou sans l'assistance d'un plasma.

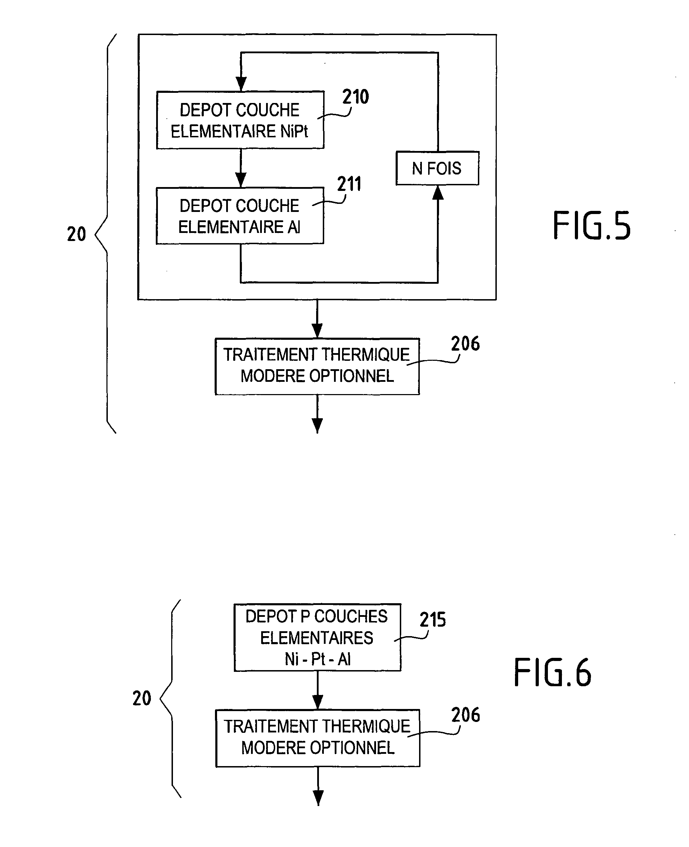

Selon une première variante (figure 4), l'étape 20 comprend la répétition M fois d'une séquence de dépôts de couches élémentaires de platine (étape 201), d'aluminium (étape 202), de platine (étape 203) et de nickel (étape 204) puis, ensuite, un dépôt final d'une couche élémentaire de platine (étape 205). Un traitement thermique modéré (étape 206) peut être effectué avant formation de la couche externe en céramique, de manière à former un composé intermétallique par réaction entre les métaux des couches élémentaires. Le traitement thermique est réalisé à une température inférieure à 900°C, par exemple de l'ordre de 700°C, de sorte qu'une diffusion d'éléments du substrat dans la partie adjacente du composé intermétallique n'est pas favorisée. Le traitement thermique est réalisé sous vide ou sous atmosphère neutre pendant une durée comprise par exemple entre 0,5 h et 3 h.

On notera que le traitement thermique modéré est optionnel, le composé intermétallique pouvant aussi être formé sous l'effet de l'élévation de température pendant la réalisation de la couche externe en céramique.

On notera aussi que, dans la séquence de dépôts élémentaires, une couche élémentaire d'aluminium est de préférence placée entre deux couches élémentaires de platine pour éviter une réaction entre aluminium et nickel qui pourrait perturber la diffusion du platine dans le composé intermétallique. La première couche élémentaire est une couche constituée essentiellement de platine, qui est moins susceptible de diffuser dans le substrat. La dernière couche élémentaire est également de préférence une couche de platine, qui est moins susceptible de s'oxyder sous air ou pression partielle d'oxygène à la fin de l'élaboration de la sous-couche de liaison.

Les couches élémentaires sont réalisées avec une épaisseur individuelle, au moins pour l'aluminium, inférieure à 2 000 nm, de préférence au plus égale à 1 500 nm. Cette épaisseur pourra être choisie nettement inférieure à ce seuil, par exemple au plus égale à 200 nm. Une telle épaisseur relativement faible sera choisie si, après traitement thermique, on désire obtenir une structure homogène, c'est-à-dire ne laissant pas subsister de trace de la réalisation de la sous-couche de liaison en couches superposées.

Le nombre M de séquences est déterminé en fonction des épaisseurs des couches élémentaires et de l'épaisseur totale souhaitée pour la sous-couche de liaison. Selon la valeur de cette épaisseur, le nombre de couches élémentaires peut varier de plusieurs unités à plusieurs dizaines, voire même plusieurs centaines.

On notera que les couches élémentaires, telles que déposées, peuvent avoir des épaisseurs différentes,

Dans tous les cas, les rapports entre les épaisseurs totales des couches pour chaque métal sont fonction de la composition souhaitée du composé intermétallique formant la sous-couche de liaison.

Selon une deuxième variante (figure 5), l'étape 20 comprend la répétition N fois d'une séquence de dépôts de couches élémentaires d'un système binaire, par exemple NiPt (étape 210), et d'aluminium (étape 211), avant traitement thermique modéré optionnel (étape 206) comme dans le processus de la figure 4. On pourrait bien sûr, en variante alterner des dépôts de système binaire PtAl et de nickel Ni. La composition du système binaire NiPt, les épaisseurs des couches élémentaires et leur nombre sont choisis en fonction de la composition et de l'épaisseur souhaitée de la sous-couche de liaison.

Selon une troisième variante (figure 6), l'étape 20 comprend le dépôt successif de P couches d'un système ternaire Ni-Pt-Al (étape 215), avant traitement thermique modéré optionnel (étape 206).

On confère à chaque couche une composition correspondant à celle désirée pour la sous-couche de liaison.

Dans les processus des figures 4 à 6 décrits ci-avant, notamment dans le cas de processus PVD, on utilise des sources ou cibles formées de nickel, de platine ou d'aluminium, ou formées d'un alliage de deux de ces métaux, ou formées d'un alliage des trois métaux, les métaux étant présents par exemple sous forme de poudre. Lorsque des métaux ou autres éléments supplémentaires doivent aussi être incorporés dans la sous-couche de liaison, ils peuvent être fournis par des sources ou cibles supplémentaires pour être déposés en couches élémentaires distinctes, ou être préalablement alliés dans la proportion souhaitée à l'une au moins des sources ou cibles de nickel et/ou de platine et/ou d'aluminium.

Selon encore une autre variante, la sous-couche de liaison peut être formée par dépôt électrolytique sans interaction sensible avec le substrat. On peut procéder par dépôts successifs de couches des différents métaux ou par co-dépôts de ceux-ci.

### Deuxième mode de réalisation

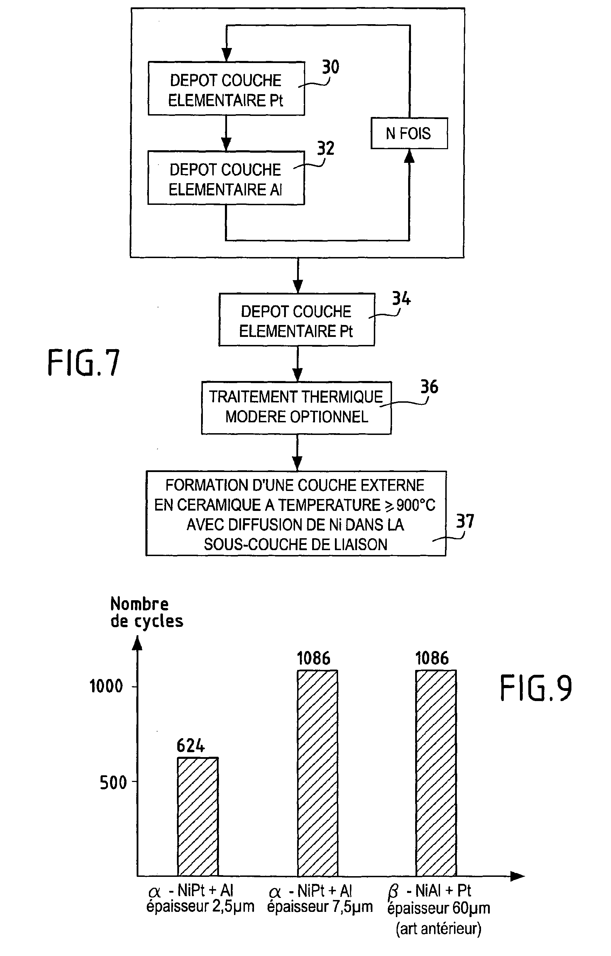

Selon un deuxième mode de réalisation (figure 7), avec un substrat métallique en superalliage à base de nickel, la sous-couche de liaison est réalisée en formant, dans une première partie du processus, un composé intermétallique comprenant essentiellement de l'aluminium et du platine et, dans une partie ultérieure du processus, en provoquant la diffusion de nickel du substrat par élévation de température avant ou pendant la formation de la couche externe céramique.

La première partie du processus peut être réalisée par dépôts alternés de couches élémentaires de platine (étape 30) et d'aluminium (étape 32), selon un processus de dépôt physique en phase vapeur, et par réaction exothermique entre les couches formées. On peut utiliser à cet effet le procédé décrit dans la demande de brevet US 2002 0037220 déjà cité.

Pour les raisons déjà indiquées, la première couche élémentaire déposée sur le substrat et la dernière couche élémentaire déposée (étape 34) sont de préférence des couches de platine.

Une étape 36 de traitement thermique modéré est réalisée de manière à former un composé intermétallique par réaction exothermique entre le platine et l'aluminium des couches élémentaires formées. Le traitement thermique est réalisé à température inférieure à 900°C, par exemple de l'ordre de 700°C, de sorte qu'une diffusion d'éléments du substrat métallique dans la partie adjacente du composé intermétallique n'est pas favorisée. Le traitement thermique est réalisé sous atmosphère non oxydante, par exemple sous vide ou atmosphère neutre pendant une durée comprise entre 0,5 et 3 h, par exemple environ 2 h. Lors du traitement thermique, l'aluminium d'une couche diffuse dans les couches adjacentes en platine. Un film fin d'alumine se développe à la surface de la sous-couche de liaison ainsi obtenue lors d'une exposition ultérieure à un milieu oxydant.

Les couches élémentaires sont réalisées avec une épaisseur individuelle, au moins pour l'aluminium, inférieure à 2000 nm, de préférence au plus égale à 1500 nm. Cette épaisseur pourra être choisie nettement inférieure à ce seuil, par exemple au plus égale à 200 nm.

L'épaisseur et le nombre des couches sont choisis pour obtenir un rapport Al/Pt correspondant à celui souhaité dans la sous-couche de liaison et pour obtenir l'épaisseur souhaitée de cette dernière.

Le dépôt des couches élémentaires de platine et d'aluminium peut être réalisé par pulvérisation cathodique, par dépôt physique en phase vapeur sous faisceau d'électrons, ou par évaporation sous arc avec ou sans plasma, ces processus permettant de maîtriser assez précisément la quantité de métal déposé, donc l'épaisseur des couches élémentaires. Il s'agit de processus bien connus en eux-mêmes utilisant des sources ou cibles de platine et d'aluminium.

Le dépôt d'au moins un métal supplémentaire et/ou d'au moins un élément réactif au sein de la sous-couche de liaison peut être réalisé en utilisant une ou plusieurs sources ou cibles supplémentaires, ou en les incorporant dans les sources ou cibles de platine et d'aluminium.

La couche externe en céramique (étape 37) est ensuite réalisée, mais en portant la température du substrat à une valeur suffisante pour provoquer la diffusion au sein de la sous-couche de liaison de nickel contenu dans le substrat métallique. Cette température doit être choisie à une valeur d'autant plus élevée que l'épaisseur de la sous-couche de liaison est grande. Elle est de préférence au moins égale à 900°C pour une épaisseur de 2 microns à 10 microns et peut dépasser 1000°C pour une épaisseur plus grande.

D'autres métaux du substrat sont également susceptibles de diffuser, tel que le cobalt et le chrome. Toutefois, la sous-couche de liaison conserve sa fonction de barrière de diffusion vis-à-vis d'éléments pouvant être contenus dans le substrat, tels que tungstène, molybdène, tantale, qui peuvent avoir un effet nocif vis-à-vis de la tenue de la tenue du revêtement de protection, notamment de la persistance du film d'alumine à la surface de la sous-couche de liaison.

La demanderesse a pu mettre en évidence que le nickel diffusant dans la sous-couche de liaison forme avec le platine une phase stable de type α-NiPt.

En variante, le traitement thermique à une température d'au moins 900°C visant à faire diffuser dans la sous-couche de liaison du nickel du substrat peut être réalisé séparément, avant formation de la couche externe en céramique.

### Exemple 1

On a utilisé des pièces métalliques en superalliage monocristallin à base nickel ayant comme composition (en pourcentages massiques) : 6,5 % Co, 7,5 % Cr, 5,3 % Al, 1,2 % Ti, 8 % Ta, 2 % Mo, 5,5 % W et complément Ni.

Des pièces ont été munies de couches alternativement en platine et en aluminium par un processus de dépôt physique en phase vapeur par pulvérisation cathodique, selon le deuxième mode de réalisation décrit plus haut (Figure 7). On a procédé au dépôt de 84 couches élémentaires de platine ayant chacune une épaisseur de 30 nm alternant avec le dépôt de 83 couches élémentaires d'aluminium ayant chacune une épaisseur de 66 nm.

La température a été élevée jusqu'à 700°C pendant 2 heures pour déclencher une réaction exothermique entre les couches élémentaires conduisant à la formation d'une couche d'épaisseur de 7,5 µm en un composé intermétallique platine-aluminium de type PtAl₂.

On a procédé ensuite au dépôt d'une couche externe céramique en zircone ZrO₂, stabilisée par de l'oxyde d'yttrium Y₂O₃ (à raison de 8 % en poids). Le dépôt a été effectué comme décrit ci-avant par dépôt physique en phase vapeur sous faisceau d'électrons. La température des substrats a été portée à 1000°C environ et la durée a été choisie pour former une couche externe de zircone yttriée d'épaisseur égale à environ 125 µm.

### Exemple 2

On a procédé comme dans l'exemple 1, mais en limitant le nombre de couches élémentaires de platine et d'aluminium pour obtenir, après réaction exothermique entre celles-ci, une couche de composé intermétallique de type PtAl₂ d'épaisseur égale à environ 2,5 µm.

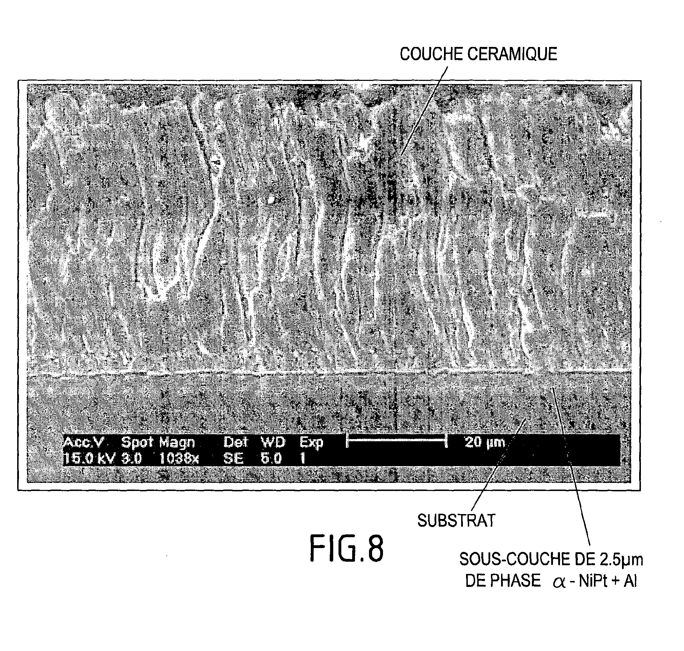

La microphotographie de la figure 8 montre le résultat obtenu.

### Exemple 3 (comparatif)

Sur des substrats de même composition que celui des exemples 1 et 2, on a formé une sous-couche de liaison par dépôt électrolytique d'une couche de platine et aluminisation en phase vapeur pour obtenir, comme de façon connue dans l'art antérieur, une sous-couche de liaison correspondant à une phase de type β du diagramme binaire Ni-Al additionnée de platine. L'épaisseur de la sous-couche de liaison était de 60 µm. On a ensuite formé une couche externe en céramique comme décrit dans l'exemple 1.

Des essais de tenue en cyclage thermique en milieu oxydant (sous air) ont été effectués sur des pièces A, B et C obtenues selon les exemples 1, 2, 3, respectivement, chaque cycle comprenant une élévation rapide de la température jusqu'à 1100°C et maintien pendant 1 heure à cette température puis retour à température ambiante et maintien pendant 15 minutes.

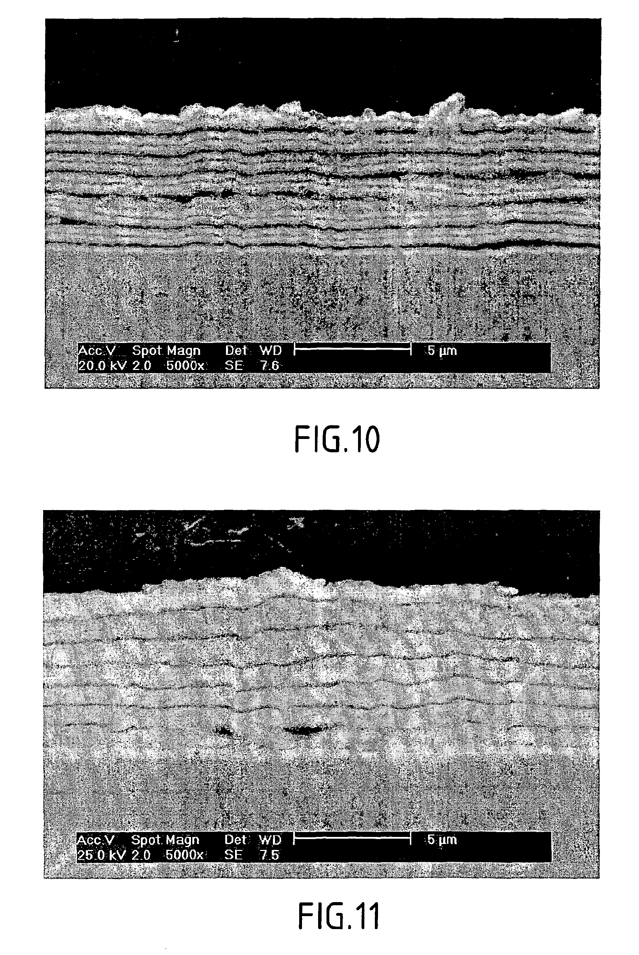

Comme montré par la figure 9, les pièces B ont montré une tenue satisfaisante jusqu'à 624 cycles, ce qui est un résultat tout à fait remarquable compte tenu de la très faible épaisseur (2,5 microns) de la sous-couche de liaison, en comparaison avec les épaisseurs de sous-couches de liaison utilisées aujourd'hui (couramment 60 microns). Pour les pièces A et C, la tenue s'est avérée satisfaisante jusqu'à 1086 cycles.

La possibilité d'une faible épaisseur de la sous-couche de liaison se traduit par une mise en oeuvre plus rapide, une économie de coût de matière (en dépit de la teneur relativement élevée en platine) et une masse réduite, ce qui constitue des avantages déterminants.

### Exemple 4

Une pièce métallique en superalliage monocristallin tel que défini dans l'exemple 1 a été munie de couches suivant une répétition de la séquence Pt, Al, Pt, Ni avec une couche finale Pt (variante illustrée par la figure 4 du premier mode de réalisation décrit plus haut). On a utilisé un processus de dépôt physique en phase vapeur par pulvérisation cathodique. Ont été déposées 13 couches élémentaires de Pt ayant chacune une épaisseur de 181 nm environ, 6 couches élémentaires de Ni ayant chacune une épaisseur de 268 nm environ et 6 couches élémentaires d'Al ayant chacune une épaisseur de 171 nm environ.

Un traitement thermique à une température d'environ 700°C sous vide a été effectué pour déclencher une réaction entre les couches élémentaires, sans provoquer de migration à partir du substrat en superalliage monocristallin. On a obtenu ainsi un revêtement en un composé intermétallique d'épaisseur environ égale à 7,1 µm. La composition en pourcentages atomiques, du revêtement était 45 % Pt, 28 % Al et 27 % Ni. L'examen du revêtement par diffraction X a permis de vérifier l'existence d'une structure cristallographique caractéristique d'une phase α-NiPt enrichie en aluminium.

Les figures 10 et 11 montrent le revêtement, en coupe, avant et après traitement thermique, respectivement.

## Revendications

1. Pièce de turbine à gaz comprenant un substrat métallique en superalliage, une sous-couche de liaison formée sur le substrat et comportant un composé intermétallique comprenant de l'aluminium, du nickel et du platine, et un revêtement externe en céramique ancré sur un film d'alumine formé sur la sous-couche de liaison,
**caractérisée en ce que** la sous-couche de liaison comprend essentiellement un système ternaire Ni-Pt-Al constitué d'une structure de type α-NiPt additionnée d'aluminium.

2. Pièce de turbine à gaz selon la revendication 1, **caractérisée en ce que** le système ternaire Ni-Pt-Al a une composition Ni_{z}Pt_{y}Alₓ dans laquelle z, y, x sont tels que 0,05 ≤ z ≤ 0,40, 0,30 ≤ y ≤ 0,60 et 0,15 ≤ x ≤ 0,40.

3. Pièce de turbine à gaz selon l'une quelconque des revendications 1 et 2, **caractérisée en ce que** la sous-couche de liaison comprend en outre au moins un métal supplémentaire autre qu'aluminium, nickel et platine.

4. Pièce de turbine à gaz selon la revendication 3, **caractérisée en ce que** la sous-couche de liaison comprend en outre au moins un métal choisi parmi le cobalt et le chrome.

5. Pièce de turbine à gaz selon l'une quelconque des revendications 3 et 4, **caractérisée en ce que** la sous-couche de liaison comprend au moins un métal choisi parmi le palladium, le ruthénium et le rhénium.

6. Pièce de turbine à gaz selon l'une quelconque des revendications 1 à 5, **caractérisée en ce que** la sous-couche de liaison comprend en outre au moins un élément réactif choisi dans le groupe constitué par l'yttrium, le zirconium, l'hafnium et les lanthanides.

7. Pièce de turbine à gaz selon l'une quelconque des revendications 1 à 6, **caractérisée en ce que** la sous-couche de liaison a une épaisseur comprise entre 2 microns et 120 microns.

8. Pièce de turbine à gaz selon la revendication 7, **caractérisée en ce que** la sous-couche de liaison a une épaisseur inférieure à 40 microns.

9. Pièce de turbine à gaz selon la revendication 7, **caractérisée en ce que** la sous-couche de liaison a une épaisseur inférieure à 20 microns.

10. Procédé de formation d'un revêtement de protection thermique sur un substrat métallique en superalliage, comprenant la formation, sur le substrat, d'une sous-couche de liaison comportant un composé intermétallique comprenant de l'aluminium, du nickel et du platine, et la formation d'une couche externe en céramique qui s'ancre sur un film d'alumine présent sur la sous-couche de liaison, **caractérisé en ce que** l'on forme une sous-couche de liaison comprenant essentiellement un système ternaire Ni-Pt-Al constitué d'une structure α-NiPt additionnée d'aluminium.

11. Procédé selon la revendication 10, **caractérisé en ce que** la sous-couche de liaison est réalisée par formation sur le substrat d'un revêtement de composition correspondant à la composition souhaitée de la sous-couche.

12. Procédé selon la revendication 11, **caractérisé en ce que** la sous-couche de liaison est réalisée par formation d'un revêtement par dépôt physique en phase vapeur.

13. Procédé selon la revendication 12, **caractérisé en ce que** la sous-couche de liaison est formée par dépôt physique en phase vapeur d'au moins une pluralité de couches élémentaires respectivement en platine, nickel et aluminium, et par réaction entre les métaux des couches déposées.

14. Procédé selon la revendication 12, **caractérisé en ce que** la sous-couche de liaison est formée par dépôts de couches dont certaines au moins comportent plusieurs composants de la sous-couche sous forme préalliée.

15. Procédé selon la revendication 12, **caractérisé en ce que** la sous-couche de liaison est formée par dépôt d'une composition préalliée correspondant à la composition souhaitée de la sous-couche.

16. Procédé selon la revendication 11, **caractérisé en ce que** la sous-couche de liaison est réalisée par formation d'un revêtement par dépôt électrolytique.

17. Procédé selon la revendication 10, **caractérisé en ce que** la sous-couche de liaison est formée sur un substrat en superalliage à base nickel, par dépôt physique en phase vapeur d'au moins une pluralité de couches élémentaires alternativement en platine et en aluminium, par réaction exothermique entre les métaux des couches déposées, et par traitement thermique à une température au moins égale à 900°C afin de provoquer la diffusion dans la sous-couche de liaison de nickel provenant du substrat.

18. Procédé selon la revendication 16, **caractérisé en ce que** le traitement thermique à une température au moins égale à 900°C est réalisé pendant la formation de la couche externe en céramique.

19. Procédé selon la revendication 16, **caractérisé en ce que** le traitement thermique à une température au moins égale à 900°C est réalisé avant la formation de la couche externe en céramique.
